# EUROPÄISCHE PATENTSCHRIFT

(11) **EP 0 834 965 B1**
(45) Veröffentlichungstag und Bekanntmachung des Hinweises auf die Patenterteilung: **06.10.1999**
(21) Anmeldenummer: 97122019.9
(22) Anmeldetag: 08.07.1994
(51) Int. Cl.: H01R 13/658, H05K 7/00, H05K 9/00

(54) **Abgeschirmtes Gehäuse für ein Verteilerfeld**
Shielded housing for distribution assembly
Boîtier blindé pour tableau de distribution

(30) Priorität: 23.07.1993 DE 4324798
(43) Veröffentlichungstag der Anmeldung: 08.04.1998
(62) Teilanmeldung aus: 94110633.8
(73) Patentinhaber: TKM Telekommunikation und Elektronik GmbH, 41236 Mönchengladbach (DE)
(72) Erfinder: Gerlach, Bernd, 64297 Darmstadt (DE)
(74) Vertreter: Meyer, Ludgerus A., Dipl.-Ing.

(56) Entgegenhaltungen:
- EP-A- 0 488 099
- DE-U- 8 002 728
- DE-U- 9 202 912
- DE-U- 9 217 572

## Beschreibung

Die Erfindung betrifft ein abgeschirmtes Gehäuse für ein Verteilerfeld.

Hohe Übertragungsraten in der modernen Datentechnik erfordern hoch abgeschirmte Kabel und immer stärker geschirmte Verteilergehäuse. Da beispielsweise bis 24 Kabel mit verschiedenen Durchmessern oder verschiedenen Abschirmungsmethoden, z. B. Folienschirmung oder Geflechtschirmung im Handel sind, ist eine ausreichende Schirmung nur schwer zu realisieren.

Übliche hochgeschirmte Verteilerfelder, z. B. für RJ 45-Verteilerfelder im modularen Aufbau sind beispielsweise als 19-Zoll-Gehäuse ausgebildet, wobei sie ein geschlossenes Gehäuse mit einer vorderseitigen Anschlußreihe von RJ-45 Buchsen enthalten. Die Kabel werden von der Rückseite des Gehäuses durch Kabeldurchführungen in das Innere geführt und dort mit Anschlußklemmen der Buchsen verbunden.

Aus dem DE-GM 80 02 728 ist ein Abschirmgehäuse für eine elektrische Schaltung bekannt, das von einem Außengehäuse umgeben ist. In das Abschirmgehäuse sind Kabel einführbar, die nebeneinanderliegend mit Anschlußklemmen im Abschirmgehäuse verbindbar sind. Die Kabelabschirmung der einzuführenden Kabel ist elektrisch leitend mit dem Abschirmgehäuse verbindbar.

Aus dem DE-GM 92 02 912 ist ein elektrische Buchsen aufweisender geschirmter Frontabschluß für Gehäuse bekannt. Die nebeneinanderliegenden Kabel sind mit Anschlußklemmen im Gehäuse verbindbar. Zur Befestigung der Kabel ist innerhalb des Gehäuses eine Montageplatte mit Befestigungsmitteln vorgesehen.

Die Schirmeigenschaften der vorgenannten Ausführungen sind für hohe Anforderungen jedoch nicht ausreichend.

Der Erfindung liegt die Aufgabe zugrunde, ein abgeschirmtes Gehäuse für ein Verteilerfeld anzugeben, das einfach montiert werden kann und dessen Handhabung weiter verbessert ist.

Diese Aufgabe wird durch die im Anspruch 1 angegebene Erfindung gelöst. Vorteilhafte Weiterbildungen der Erfindung sind in Unteransprüchen angegeben.

Bei dem Gehäuse der im Oberbegriff des Anspruchs 1 angegebenen Art werden erfindungsgemäß die Kabel zwischen einem Rand der Abdeckung und der Montageplatte hindurchgeführt, wobei ein Kontaktkamm an dem den Kabeln angeordneten Rand des Gehäuses die freigelegten Kabelisolierungen kontaktiert.

Trotz der guten Schirmung des Gehäuses des Verteilerfeldes gestaltet sich die Montage einfach, da lediglich die Abdeckung auf die Montageplatte aufzusetzen ist, und die Kabel dabei sowohl kontaktiert als auch festgelegt werden.

Der Kontaktkamm drückt bei Aufsetzen der Abdeckung auf die Kabel, und der Kontaktkamm bildet Kontaktierungen mit der Montageplatte. Die Kontaktierung der Abdeckung ergibt sich somit selbsttätig beim Aufsetzen der Abdeckung auf die Montageplatte.

Die Montage des Verteilerfeldes gestaltet sich beispielsweise folgendermaßen: zunächst werden die Kabel auf eine gewisse Länge von der Außenisolierung befreit. Dann werden die Kabel auf einem ebenen vorderen Bereich der Montageplatte mittels Klemmen befestigt. Die einzelnen Leiter der Kabel können dann an Anschlußklemmen einer Buchse, insbesondere RJ-45 Buchse, befestigt werden. Der Beidraht des Kabels wird um eine Ausstanzung im Schrägbereich der Montageplatte gelegt. Wenn das Kabel dann niedergedrückt wird, wird die Stanzzunge in die Ursprungsstellung zurückgedrückt und klemmt damit den Beidraht ein. Danach wird die Abdeckung auf die Montageplatte aufgesetzt, wobei der Kontaktkamm der Abdeckung auf den Abschirmungen der Kabel zu liegen kommt, bzw. unmittelbaren Kontakt mit der Montageplatte erhält.

Die erfindungsgemäße Ausbildung des Verteilerfeldes erlaubt in allen Bereichen eine Kontaktierung mit den eingeführten Kabeln, den entsprechenden Kontaktbuchse und der Montageplatte. Das Verteilerfeld ist montagefreundlich, schnell zu montieren und kostengünstig herstellbar. Es ergibt sich nur eine sehr geringe Anzahl von Teilen.

Auch im unbelegten Zustand von Anschlußklemmen ergibt sich ein ständiger Erdungskontakt der Abdeckung.

Die Erfindung wird nachstehend anhand eines Ausführungsbeispiels näher erläutert. Es zeigen
- Fig. 1: eine teilweise weggebrochene perspektivische Ansicht eines Verteilerfeldes,
- Fig. 2: eine Schnittansicht eines Verteilerfeldes von Fig. 1, und
- Fig. 3: eine Schnittansicht einer erfindungsgemäßen Ausführungsform.

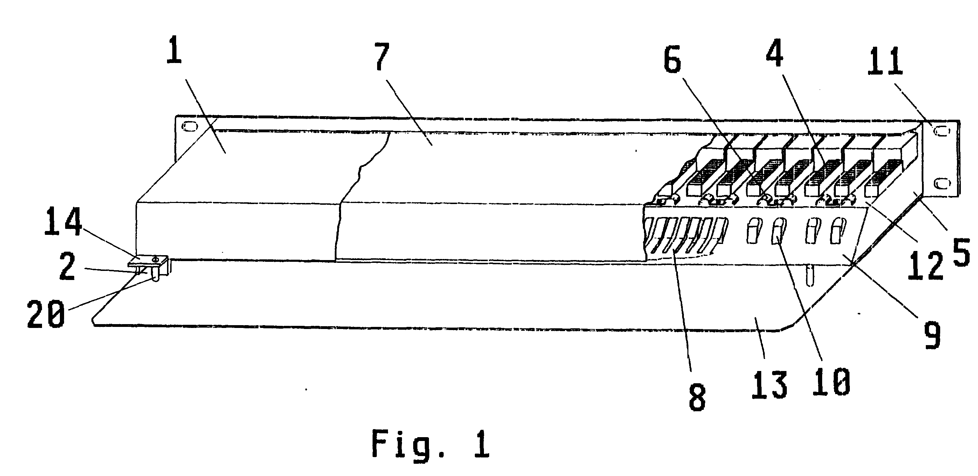

Das in Fig. 1 dargestellte Gehäuse für ein Verteilerfeld weist eine Unterplatte 13 auf, auf die ein Außengehäuse 1 aufsetzbar ist. Unterplatte 13 und Außengehäuse 1 sind mit der Frontplatte 11 verbunden, beispielsweise über eine Schraubverbindung. Am unteren Rand des Außengehäuses 1 befindet sich eine Öffnung 2, der eine Klemme 14 zugeordnet ist. Diese dient im wesentlichen der Zugentlastung eines durch die Öffnung 2 hindurchgeführten Kabels. Die Klemme 14 ist durch eine rechtwinklige Abkantung des Außengehäuses 1 gebildet, die über eine Schraubverbindung mit einem Stift 20 verschraubbar ist, der an der Unterplatte 13 befestigt ist. Durch Festschrauben der Klemme 14 über den Stift 20 wird einerseits eine Klemmung des eingeführten Kabels ereicht, andererseits erfolgt damit eine Befestigung von Außengehäuse 1 und Unterplatte 13.

Im Inneren des Außengehäuses befindet sich eine Abdeckung 7, deren Querschnittsform im wesentlichen der Querschnittsforms des Außengehäuses folgt. Die Abdeckung deckt eine Montageplatte 5 ab, die auf der Unterplatte 13 befestigt ist. Die Montageplatte ist pultartig mit einem ebenen Bereich 12 und einem Schrägbereich 9 aufgebaut. Auf dem ebenen, mit Abstand zur Unterplatte 13 angeordneten Bereich befinden sich Klemmen 6 zur Festlegung von einzuführenden Kabel sowie die Anschlußklemmen 4 zur Befestigung der Leiter des einzuführenden Kabels. Die Anschlußklemmen 4 führen zu Buchsen, insbesondere RJ-45 Buchsen, die von der Vorderseite des Verteilerfeldes zugänglich sind.

Im Schrägbereich 9 der Montageplatte 5 sind U-förmige Stanzzungen 10 dargestellt, die nach oben unter einem spitzen Winkel zum Schrägbereich 9 der Montageplatte 5 ausgebildet sind. In ihrem vorderen Bereich sind sie abgekantet, so daß sie in diesem Bereich im wesentlichen parallel zum Schrägbereich 9 liegen.

Die Abdeckung 7 weist an der unteren, der Montageplatte 5 zugeordneten Kante eine nach innen gerichtete Abkantung auf, die kammartig gestanzt ist und auf diese Weise Kontaktfedern 8 bildet. Diese liegen im Ruhezustand auf den Stanzzungen 10 auf. Sie stehen daher in elektrischem Kontakt mit der Montageplatte 5.

Das Verteilerfeld ist zur Aufnahme von bis zu 24 Kabeln vorgesehen. Jedes Kabel wird über eine Klemme 6 befestigt und mit den Anschlußklemmen 4 verbunden. Die Kabel werden zwischen Abdeckung 7 und Montageplatte 5 hindurchgeführt, wobei die Kontaktfedern 8 auf den Kabeln zu liegen kommen. Wenn die Kabel entsprechend weit von ihrer äußeren Isolierung befreit sind, liegen die Kontaktfedern 8 auf der Abschirmung des Kabels auf. Über die Abschirmung des Kabels wird daher ein Kontakt von Kontaktfeder 8 und Montageplatte 5 mit der Abschirmung des Kabels hergestellt.

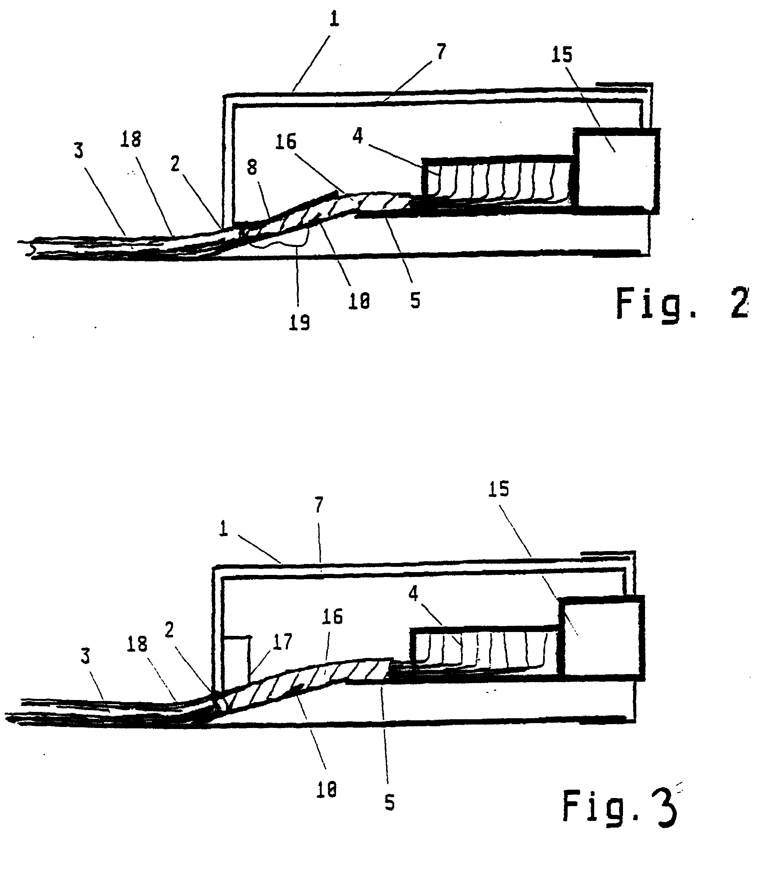

Fig. 2 zeigt eine Schnittansicht durch ein Gehäuse gemäß Figur 1. Das Kabel 3 wird von der Rückseite des Außengehäuses 1 eingeführt und über den Schrägbereich 9 an die Anschlußklemmen 4 geführt. Die Buchse 15 schließt sich unmittelbar an die Anschlußklemmen 4 an. Die Figur zeigt, wie die Kontaktfedern 8 auf der Abschirmung 16 des Kabels 3 aufliegen. Die Isolierung 18 des Kabels 3 endet innerhalb des Außengehäuses 1, so daß die Klemmung des Kabels über die Klemme 14 die Außenisolierung 18 erfaßt. Der im Kabel 3 mitgeführte Beidraht 19 ist um die Stanzzungen 10 gewickelt und wird durch den Andruck der Kontaktfedern 8 und des Kabels 3 an der Montageplatte 5 geklemmt.

Fig. 3 zeigt eine Ausführungsform der Erfindung, bei der anstelle von abgekanteten Kontaktfedern ein mit dem Abdeckgehäuse 7 verbundener Kontaktkamm vorgesehen ist, der die Kontaktierung der Abschirmung 16 der Kabel sicherstellt. Der Abdeckkamm kann auch in Form von Metallbürsten, Federn oder einem flexiblen Flechtschlauch ausgebildet sein.

Soweit die Gehäuseteile zur Montage der Kabel nicht auseinanderzunehmen sind, sind sie vorzugsweise punktverschweißt, bzw. aus abgekanteten Blechen gebildet.

Das gesamte Verteilerfeld kann insbesondere bis zu 24 Kabel aufnehmen und ist in einem 19-Zoll-Einschub ausgebildet.

### BEZUGSZEICHENLISTE

- 1: Außengehäuse
- 2: Öffnung
- 3: Kabel
- 4: Anschlußklemme
- 5: Montageplatte
- 6: Klemme
- 7: Abdeckung
- 8: Kontaktfedem
- 9: Schrägbereich
- 10: Stanzzunge
- 11: Frontplatte
- 12: ebener Bereich
- 13: Unterplatte
- 14: Klemme
- 15: Buchse
- 16: Abschirmung
- 17: Kontaktkamm
- 18: Isolierung
- 19: Beidraht
- 20: Stift

## Patentansprüche

1. Abgeschirmtes Gehäuse für ein Verteilerfeld, mit einer Einführungsöffnung (2) für von der Rückseite in das Gehäuse einführbare Kabel (3), die nebeneinanderliegend mit Anschlußklemmen (4) im Gehäuse verbindbar sind, bei dem das im wesentlichen geschlossene Gehäuse durch eine Montageplatte (5) mit Befestigungsmitteln (6) zur Befestigung der Kabel (3) und Anschlußklemmen (4), eine Frontplatte (11) und eine auf die Montageplatte (5) aufsetzbare Abdeckung (7) gebildet ist, dadurch gekennzeichnet, daß die Kabel (3) zwischen einem Rand der Abdeckung (7) und der Montageplatte (5) hindurchgeführt sind, und daß das Gehäuse an seinem den Kabeln (3) zugeordneten Rand einen parallel zur Montageplatte verlaufenden Kontaktkamm (8) zur Kontaktierung der freigelegten Kabelabschirmungen enthält.

2. Gehäuse nach Anspruch 1, dadurch gekennzeichnet, daß der Kontaktkamm (8) als Metallbürste ausgebildet ist.

3. Gehäuse nach Anspruch 1, dadurch gekennzeichnet, daß der Kontaktkamm (8) als flexibler Flechtschlauch ausgebildet ist.

4. Gehäuse nach Anspruch 1, dadurch gekennzeichnet, daß der Kontaktkamm (8) als eine Reihe von Kontaktfedern ausgebildet ist.

## Claims

1. A shielded casing for a distribution assembly with an insertion opening (2) for cables (3) which can be inserted in the casing from the rear and, lying adjacent one another, can be connected to terminals (4) in the casing, wherein the substantially closed casing is formed by a mounting plate (5) with means (6) for attaching the cables (3) and terminals (4), a front plate (11) and a covering (7) which may be placed on the mounting plate (5), characterised in that the cables (3) are taken through between an edge of the covering (7) and the mounting plate (5), and that the edge of the casing associated with the cables (3) contains a contact comb (8) extending parallel with the mounting plate, for contacting the exposed cable screens.

2. A casing according to claim 1, characterised in that the contact comb (8) is in the form of a metal brush.

3. A casing according to claim 1, characterised in that the contact comb (8) is in the form of a flexible braided tube.

4. A casing according to claim 1, characterised in that the contact comb (8) is in the form of a row of contact springs.

## Revendications

1. Boîtier blindé pour un panneau de distribution, comportant une ouverture d'introduction (2) pour des câbles (3) qui sont aptes à être introduits dans le boîtier par le côté arrière et qui sont aptes à être reliés, les uns à côté des autres, à des bornes de connexion (4) situées dans le boîtier, le boîtier globalement fermé étant défini par une plaque de montage (5) pourvue de moyens de fixation (6) pour la fixation des câbles (3) et des bornes de connexion, par une plaque frontale (11) et par un recouvrement (7) apte à être posé sur la plaque de montage (5), caractérisé en ce que les câbles (3) passent entre un bord du recouvrement (7) et la plaque de montage (5), et en ce que le boîtier contient, sur son bord associé aux câbles (3), un peigne de contact (8) parallèle à la plaque de montage (5) et destiné à établir un contact avec les blindages de câbles découverts.

2. Boîtier selon la revendication 1, caractérisé en ce que le peigne de contact (8) est conçu comme une brosse métallique.

3. Boîtier selon la revendication 1, caractérisé en ce que le peigne de contact (8) est conçu comme un tuyau tressé flexible.

4. Boîtier selon la revendication 1, caractérisé en ce que le peigne de contact (8) est conçu comme une série de ressorts de contact.
